(19) Europäisches Patentamt
European Patent Office
Office européen des brevets

(11) **EP 3 549 041 B1**

(12) **FASCICULE DE BREVET EUROPEEN**

(45) Date de publication et mention de la délivrance du brevet:
**14.08.2024 Bulletin 2024/33**

(21) Numéro de dépôt: **17822170.1**

(22) Date de dépôt: **01.12.2017**

(51) Classification Internationale des Brevets (IPC):
**G06F 30/13** (2020.01)   **G06T 17/00** (2006.01)

(52) Classification Coopérative des Brevets (CPC):
**G06F 30/13; G06T 17/00;** G06T 2210/04

(86) Numéro de dépôt international:
**PCT/EP2017/081263**

(87) Numéro de publication internationale:
**WO 2018/104183 (14.06.2018 Gazette 2018/24)**

(54) **PROCEDE DE CONSTRUCTION D'UNE MAQUETTE NUMERIQUE 3D A PARTIR D'UN PLAN 2D**

VERFAHREN ZUM ERSTELLEN EINES 3D-DIGITALMODELLS AUS EINEM 2D-PLAN

METHOD FOR CONSTRUCTING A 3D DIGITAL MODEL FROM A 2D PLAN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.12.2016 FR 1661912**

(43) Date de publication de la demande:
**09.10.2019 Bulletin 2019/41**

(73) Titulaire: **WiseBIM**
**75011 Paris (FR)**

(72) Inventeurs:
• **SUARD, Frédéric**
**73000 Jacob Bellecombette (FR)**
• **GIMENEZ, Lucile**
**94300 Vincennes (FR)**
• **ROBERT, Sylvain**
**91120 Palaiseau (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
• **L. GIMENEZ ET AL: "Automatic reconstruction of 3D building models from scanned 2D floor plans", AUTOMATION IN CONSTRUCTION, vol. 63, 23 December 2015 (2015-12-23), pages 48 - 56, XP029419399, ISSN: 0926-5805, DOI: 10.1016/J.AUTCON.2015.12.008**
• **B. OKORN ET AL: "Toward Automated Modeling of Floor Plans", PROCEEDINGS OF THE 5TH SYMPOSIUM ON 3D DATA PROCESSING, VISUALIZATION AND TRANSMISSION, PARIS, 17 May 2010 (2010-05-17) - 20 May 2010 (2010-05-20), XP055089590, DOI: 10.1.1.180.4602**

## Description

### Domaine de l'invention

L'invention se situe dans le domaine de la modélisation numérique d'un bâtiment et concerne un procédé, un dispositif et un produit programme d'ordinateur pour la construction d'une maquette numérique 3D à partir d'une ou plusieurs images de plan 2D.

### Etat de la Technique

Dans l'univers du bâtiment, il existe des méthodes de construction de maquette numérique 3D à partir de plan 2D. A partir d'un plan existant sous forme d'image (par exemple un plan papier scanné, une image d'un plan d'évacuation ou un modèle graphique d'un architecte), il est possible de construire une maquette numérique du bâtiment (aussi connue sous l'abréviation BIM pour son acronyme anglo-saxon Building Information Model). Cette maquette permet de définir la géométrie de l'enveloppe du bâtiment. Autrement dit, la maquette numérique 3D permet de visualiser l'ensemble d'un bâtiment en trois dimensions. Il est aussi possible d'y apporter éventuellement des modifications, notamment en phase de conception d'un nouveau bâtiment. Elle regroupe l'ensemble des données nécessaires pour, par exemple, la construction de l'ouvrage, c'est-à-dire les composants techniques du bâtiment, mais la maquette numérique peut aussi contenir des données indispensables à son exploitation, par exemple en termes de gestion thermique du bâtiment. Cette maquette numérique est donc un fichier numérique qui réunit l'ensemble des informations techniques des composantes d'un bâtiment, comme l'épaisseur des murs, les dimensions des fenêtres ou des poutres, éventuellement les caractéristiques techniques des équipements thermiques, la qualité des isolants et leur incidence sur la consommation énergétique. Une méthode de construction de maquette numérique 3D de l'art antérieur est décrite dans le document « Automatic reconstruction of 3D building models from scanned 2D floor plans », de Gimenez et al., AUTOMATION IN CONSTRUCTION, vol. 63, pages 48-56, XP029419399. Le document « Toward Automated Modeling of Floor Plans », de Okorn et al., Proceedings of the 5th Symposium on 3D data processing, visualization and transmission, paris, XP055089590, décrit quant à lui la création d'un modèle de plan 2D à partir d'un nuage de points 3D.

Un utilisateur souhaitant obtenir une telle maquette numérique doit donc pouvoir interpréter l'image fournie, c'est-à-dire un plan 2D, pour ajouter de l'information et de la sémantique supplémentaires et caractériser les propriétés des éléments reconstruits (porte, fenêtre, épaisseur d'un mur, ...).

Il existe des méthodes d'extrusion 3D de plans issus de la conception assistée par ordinateur (aussi connue sous son abréviation CAO ou CAD pour l'acronyme anglo-saxon Computer Aided Design). Dans ces méthodes, les données d'entrée sont issues de données au format CAO, c'est-à-dire qu'il s'agit d'images vectorisées et enregistrées sous un format qui contient des vecteurs, et non pas des pixels. Par ailleurs, aucune autre information, par exemple sur les matériaux, n'est contenue dans ces données.

Les méthodes de construction de maquettes numériques 3D à partir de plans 2D existantes se basent sur des algorithmes intervenant à différentes étapes de la méthode de reconstruction. Mais ces algorithmes nécessitent l'entrée de paramètres dépendant de concepts du domaine du traitement d'image ou de reconnaissance de formes, c'est-à-dire hors du domaine de compétence de l'utilisateur supposé, qui est généralement du domaine de l'architecture, de l'étude thermique, ou de la construction. L'utilisateur peut donc être amené à choisir de mauvais paramètres ou des paramètres mal adaptés au cas de figure qu'il traite lors de la construction de la maquette numérique. Il en résulte une maquette numérique 3D inappropriée ou incomplète. Un problème technique à résoudre consiste donc à proposer un procédé de construction d'une maquette numérique 3D à partir d'un plan 2D sans que l'utilisateur n'ait à choisir la valeur des multiples paramètres, tout en assurant une maquette numérique 3D de qualité, en correspondance avec les composantes du bâtiment.

### Résumé de l'invention

L'invention vise à pallier tout ou partie des problèmes cités plus haut en proposant un procédé de construction d'une maquette numérique 3D à partir d'une ou plusieurs images de plan 2D dans laquelle le choix des paramètres se fait automatiquement, permettant de solliciter peu ou pas l'utilisateur. Il en résulte un gain de performance et de temps, une facilité et robustesse d'utilisation du procédé car l'utilisateur n'a pas la nécessité de comprendre l'impact de l'intégralité des paramètres appliqués qui ne sont a priori pas dans ses compétences initiales.

A cet effet, l'invention a pour objet un procédé, mis en oeuvre par ordinateur, de construction d'une maquette numérique 3D d'un bâtiment à partir d'un plan 2D du bâtiment, le bâtiment ayant une géométrie définie par au moins un paramètre géométrique, le procédé comprenant une pluralité d'étapes, au moins l'une d'entre elles nécessitant une entrée d'au moins un paramètre interne, le procédé étant caractérisé en ce qu'il comprend une étape de sélection d'un ensemble de valeurs des paramètres sans intervention humaine.

Avantageusement, le procédé selon l'invention comprend en outre une étape de définition d'un indicateur de performance destiné à évaluer la performance d'un ensemble de valeurs de paramètres sélectionnées sans intervention humaine, dans lequel l'étape de sélection d'un ensemble de valeurs des paramètres sans intervention humaine comprend les étapes de calcul de l'indicateur de performance associé à chaque ensemble de valeurs de paramètres, de comparaison des indicateurs de performance calculés, et de sélection de l'ensemble de valeurs de paramètres donnant l'indicateur de performance le plus élevé parmi tous les indicateurs de performance calculés.

Selon un mode de réalisation de l'invention, le procédé comprend en outre une étape de proposition de correction des valeurs des paramètres sélectionnées sans intervention humaine, permettant à un utilisateur de choisir au moins une valeur d'au moins un paramètre, une étape de sauvegarde de la au moins une valeur choisie par l'utilisateur, de façon à constituer un historique des choix de l'utilisateur, l'étape de sélection de l'ensemble des valeurs des paramètres sans intervention humaine se faisant en prenant en compte l'historique des choix de l'utilisateur.

Selon un autre mode de réalisation de l'invention, le procédé comprend en outre une étape de sauvegarde de l'ensemble des valeurs de paramètres sélectionnées sans intervention humaine, de façon à constituer un historique des valeurs de paramètres, l'étape de sélection de l'ensemble des valeurs des paramètres sans intervention humaine se faisant en prenant en compte l'historique des valeurs de paramètres.

Selon un autre mode de réalisation de l'invention, le plan 2D comprenant des éléments graphiques, la pluralité d'étapes du procédé comprend une étape d'extraction des éléments graphiques du plan 2D, une étape d'identification des éléments graphiques de sorte à définir la géométrie du bâtiment, une étape de génération de la maquette numérique 3D.

Selon un autre mode de réalisation de l'invention, le procédé comprend après l'étape de génération de la maquette numérique 3D, une étape d'export de la maquette numérique 3D dans un format préalablement défini.

Selon un autre mode de réalisation, l'étape de génération de la maquette numérique 3D comprend les étapes suivantes de définition d'éléments extérieurs correspondant à la géométrie extérieure du bâtiment à partir des éléments graphiques, de définition d'éléments intérieurs correspondant aux éléments graphiques distincts des éléments extérieurs, d'identification de zones du bâtiment formées par un ensemble d'éléments extérieurs et/ou intérieurs formant un polygone fermé et dont la surface est supérieure à une valeur de seuil.

Selon un autre mode de réalisation, le plan 2D comprenant des éléments textuels, l'étape d'extraction des éléments graphiques est précédée d'une étape d'extraction des éléments textuels.

Selon un autre mode de réalisation, le procédé selon l'invention comprend au préalable une étape de numérisation du plan 2D pour obtenir une image numérisée.

Selon un autre mode de réalisation de l'invention, le procédé comprend, préalablement à l'étape de sélection de l'ensemble des valeurs des paramètres sans intervention humaine, une étape de détermination des valeurs possibles pour chaque paramètre parmi une grille de valeurs pour chaque paramètre.

Selon un autre mode de réalisation de l'invention, le procédé comprend, préalablement à l'étape de sélection de l'ensemble des valeurs des paramètres sans intervention humaine, une étape de détermination des valeurs possibles pour chaque paramètre par une approche méta-heuristique.

Selon un autre mode de réalisation de l'invention, le procédé comprend, préalablement à l'étape de sélection de l'ensemble des valeurs des paramètres sans intervention humaine, une étape de détermination des valeurs possibles pour chaque paramètre par une approche par méta-modèle.

L'invention concerne aussi un dispositif de construction d'une maquette numérique 3D à partir d'un plan 2D, le dispositif comprenant des moyens pour mettre en oeuvre les étapes d'un tel procédé.

L'invention concerne aussi un produit programme d'ordinateur, ledit programme d'ordinateur comprenant des instructions de code permettant d'effectuer les étapes du procédé de construction, lorsque ledit programme est exécuté sur un ordinateur.

**Description des figures**

L'invention sera mieux comprise et d'autres avantages apparaîtront à la lecture de la description détaillée d'un mode de réalisation donné à titre d'exemple, description illustrée par le dessin joint dans lequel :

- la figure 1 représente schématiquement le principe du procédé de construction d'une maquette numérique 3D d'un bâtiment à partir d'un plan 2D du bâtiment selon l'invention,
- la figure 2 représente schématiquement les étapes d'un mode de réalisation d'un procédé de construction d'une maquette numérique 3D d'un bâtiment à partir d'un plan 2D du bâtiment selon l'invention,
- la figure 3 représente schématiquement les étapes d'un autre mode de réalisation d'un procédé de construction d'une maquette numérique 3D d'un bâtiment à partir d'un plan 2D du bâtiment avec sélection d'un ensemble de valeurs des paramètres sans intervention humaine selon l'invention.

**EP 3 549 041 B1**

**Description détaillée de l'invention**

Par souci de clarté, les mêmes éléments porteront les mêmes repères dans les différentes figures.

Dans la description, l'invention est décrite avec l'exemple d'un plan 2D représentant un étage d'un bâtiment. Ce plan 2D peut être par exemple un plan papier scanné, une image d'un plan d'évacuation ou un modèle graphique d'un architecte. Cependant, l'invention est applicable de façon similaire à plusieurs plans 2D, chacun représentant un étage d'un bâtiment à plusieurs étages, l'obtention de la maquette numérique 3D du bâtiment se fait alors par assemblage ou concaténation des maquettes numériques 3D obtenues. De même, de façon analogue, l'invention s'applique aussi à un vaste étage représenté sur plusieurs plans 2D, auquel cas les images d'un étage sur plusieurs fichiers peuvent être concaténées avant la construction de la maquette numérique 3D.

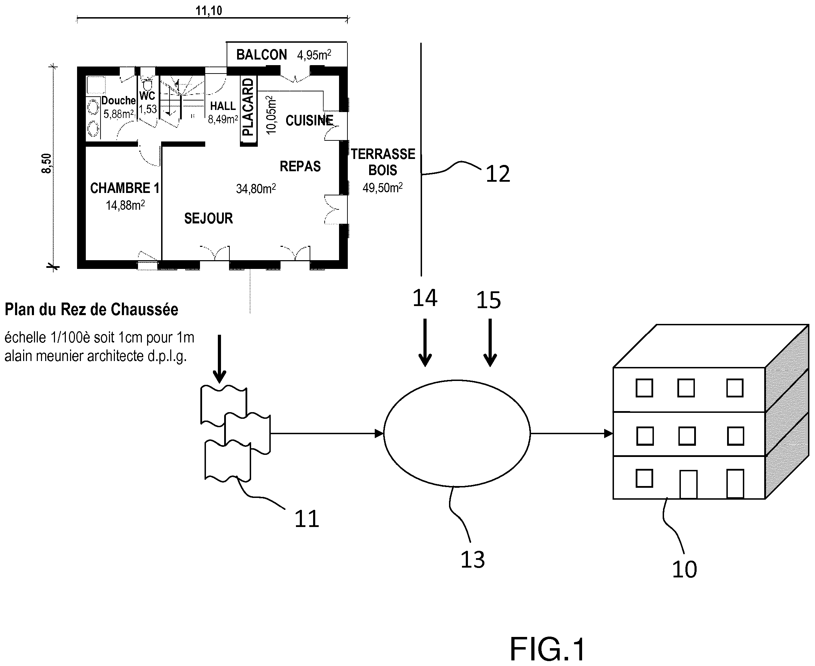

La **figure 1** représente schématiquement le principe du procédé de construction d'une maquette numérique 3D 10 d'un bâtiment à partir d'un plan 2D 11 du bâtiment selon l'invention. Le procédé selon l'invention permet de construire à partir d'un plan 11, 12 existant sous forme d'image, une maquette numérique 10 du bâtiment. Cette maquette est appelée BIM pour son acronyme anglo-saxon Building Information Model. Cette maquette numérique 10 permet de définir la géométrie de l'enveloppe du bâtiment. La particularité d'un tel procédé de construction réside dans la capacité à interpréter l'image 11, 12 fournie pour ajouter de l'information supplémentaire (sémantique) et identifier le type de l'élément présent dans le plan. En plus de l'identification, le procédé selon l'invention permet de valider la cohérence de la reconstruction en veillant à garantir l'intégrité globale du point de vue de l'enveloppe du bâtiment.

Le procédé, mis en oeuvre par ordinateur, de construction de la maquette numérique 3D 10 du bâtiment à partir d'un ou des plans 2D 11, 12 du bâtiment comprend une pluralité d'étapes 13. Au moins l'une d'entre elles nécessite une entrée d'au moins un paramètre interne (notamment des paramètres internes aux algorithmes utilisés). Par ailleurs, le bâtiment a une géométrie définie par au moins un paramètre géométrique (par exemple épaisseur des murs, hauteur des portes, hauteur des fenêtres, etc.). Comme expliqué précédemment, la difficulté de la mise en oeuvre d'un tel procédé réside notamment sur le choix des paramètres intrinsèques aux algorithmes implémentés. Selon l'invention, le procédé de construction comprend une étape 102 de sélection d'un ensemble de valeurs des paramètres sans intervention humaine. Le procédé selon l'invention permet donc de progresser en efficacité en réduisant les erreurs ou incomplétudes de reconstruction et aussi le temps nécessaire pour produire une maquette numérique car il peut proposer des valeurs de paramètres adéquates, sans que l'utilisateur n'ait de compétences spécifiques au domaine du traitement d'images. Le procédé peut comprendre une étape d'affichage de la maquette numérique 3D sur un écran, par exemple un écran d'ordinateur, pour permettre la visualisation du bâtiment en trois dimensions, par exemple à des fins d'aide à la conception, et/ou pour permettre de naviguer virtuellement à l'intérieur. Grâce au procédé selon l'invention, il est également possible d'apporter des modifications à la maquette. Par exemple, un futur propriétaire peut à partir des plans 2D fournis par l'architecte visualiser sa future maison en 3D, naviguer à l'intérieur de la maquette et éventuellement demander une modification par exemple sur le positionnement d'une paroi ou d'une fenêtre.

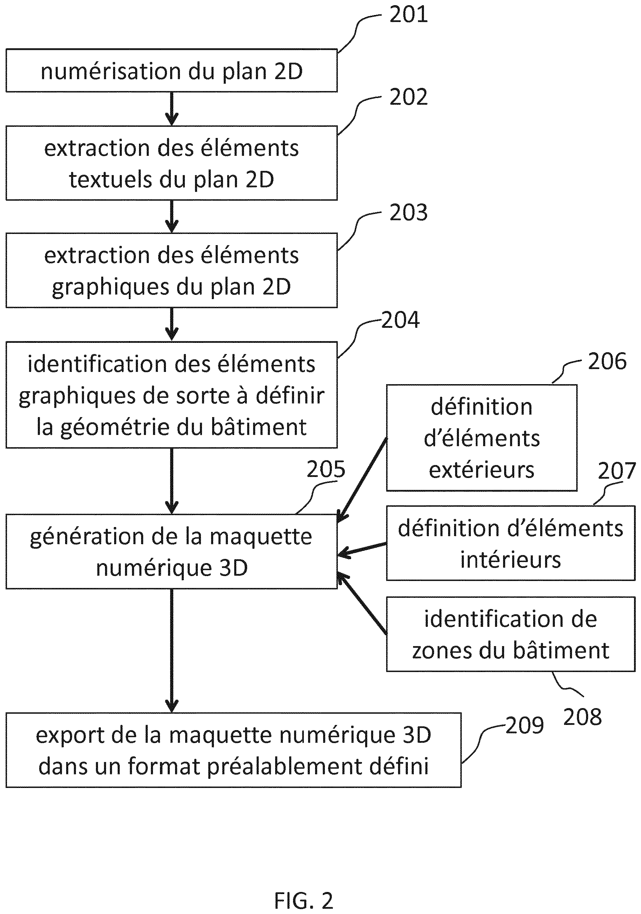

La **figure 2** représente schématiquement les étapes d'un mode de réalisation d'un procédé de construction d'une maquette numérique 3D d'un bâtiment à partir d'un plan 2D du bâtiment selon l'invention. Le plan 2D comprenant des éléments graphiques, et la pluralité d'étapes comprend une étape 203 d'extraction des éléments graphiques du plan 2D, une étape 204 d'identification des éléments graphiques de sorte à définir la géométrie du bâtiment, et une étape 205 de génération de la maquette numérique 3D.

Après l'étape 205 de génération de la maquette numérique 3D, le procédé selon l'invention peut comprendre une étape 209 d'export de la maquette numérique 3D dans un format préalablement défini. Cette étape 209, avantageusement mais non obligatoire, consiste à générer un modèle exploitable par d'autres outils. Il s'agit en fait de décrire l'ensemble des éléments du bâtiment dans un format compatible avec d'autres logiciels, par exemple le format IFC (pour l'acronyme anglo-saxon Industry Foundation Classes). Ce format permet d'enregistrer dans un fichier textuel l'ensemble des éléments en respectant une hiérarchie propre au format respectant la décomposition du bâtiment en étage, pièce, élément (mur/ouvrant). La description basique est géométrique, les informations extraites durant le procédé sont donc suffisantes. Il est cependant possible d'étendre la description des éléments en ajoutant des propriétés spécifiques telles que le type de matériau, la date de construction, etc.

Selon un mode de réalisation du procédé, l'étape 205 de génération de la maquette numérique 3D comprend une étape 206 de définition d'éléments extérieurs correspondant à la géométrie extérieure du bâtiment à partir des éléments graphiques, une étape 207 de définition d'éléments intérieurs correspondant aux éléments graphiques distincts des éléments extérieurs, et une étape 208 d'identification de zones du bâtiment formées par un ensemble d'éléments extérieurs et/ou intérieurs formant un polygone fermé et dont la surface est supérieure à une valeur de seuil.

Avantageusement, si le plan 2D comprend des éléments textuels, l'étape 203 d'extraction des éléments graphiques est précédée d'une étape 202 d'extraction des éléments textuels.

Si besoin, le procédé selon l'invention peut comprendre au préalable une étape 201 de numérisation du plan 2D pour obtenir une image numérisée.

Ainsi, à partir de l'image fournie initialement, un prétraitement est opéré pour nettoyer l'image des défauts ponctuels liés à la numérisation ainsi que pour effectuer une conversion de l'image en noir et blanc. Cette binarisation implique d'appliquer un seuil sur la valeur de l'image initiale pour définir l'image finale.

Un point image P est défini par ses coordonnées, ainsi que la valeur du pixel de l'image binarisée correspondant à l'emplacement dans l'image :

$$P = \left\{ \begin{array}{l} (x, y, v) \\ v = I_b(x, y) \end{array} \right.$$

avec v = 1 si la valeur du pixel correspondant dans l'image initiale est supérieure à un seuil, 0 sinon.

A partir de l'image binarisée, l'étape 202 consiste à isoler les éléments textuels de l'image, afin de ne conserver que les éléments graphiques. Pour cela, un outil de reconnaissance automatique de texte (de type OCR pour l'acronyme Optical Character Recognition ou reconnaissance optique de caractères) est appliqué sur l'ensemble de l'image afin d'isoler les zones de l'image contenant un champ textuel. Un élément textuel extrait d'une image est ainsi défini par une boite englobante ainsi qu'un champ textuel :

$$t = \{P_1, P_2, string\}$$

Il faut noter que le rectangle englobant est défini ici par les deux points P1 et P2 de sa diagonale.

Les autres éléments à extraire de l'image sont les éléments graphiques, qui seront donc l'objet de la reconnaissance ultérieure pour les éléments du bâtiment. Dans l'image, il faut identifier chaque primitive géométrique définie par un ensemble de points :

$$e = \{P_i\}_{i=2..n}$$

Ces points peuvent correspondre à un segment, un arc de cercle ou toute autre forme prédéfinie. Dans le cas de la recherche des arcs de cercles ou des segments, on peut appliquer la méthode de Hough dont le principe consiste à retenir les axes de l'image cumulant un grand nombre de points. Cette méthode permet ainsi d'identifier les segments contenus dans l'image, ainsi que les arcs de cercles.

Afin de limiter le nombre d'éléments reconnus dans l'image initiale, un filtrage des primitives géométriques est effectué. Ce filtrage permet de supprimer les segments dont la longueur est inférieure à une valeur minimale. Cette valeur est définie en fonction de la taille minimale possible d'un mur.

La finalité du procédé concerne la modélisation de l'enveloppe du bâtiment, c'est-à-dire les murs et les ouvrants. Un bâtiment est constitué d'ensembles de primitives géométriques, d'éléments textuels et de formes élémentaires (murs Bk = Bw, ouvrants Bk = Bo) :

$$B = \left\{ \{e_i\}_{i=2..n}, \{t_j\}_{j=0..p}, \{B_k\}_{k=0..q} \right\}$$

avec Bw un mur défini par un ensemble de segments d'orientation similaire, de longueur proche comprise dans un intervalle [Lmin - Lmax], et dont la distance les séparant d(e1,e2) est comprise dans un intervalle de valeurs [Emin - Emax] établi à partir des épaisseurs possibles des murs :

$$B_w = \left\{ \begin{array}{l} \{e_1, e_2\} \\ e_{1_{shape}} = e_{2_{shape}} = segment \\ e_1 // e_2 \\ E_{min} < d(e_1, e_2) < E_{max} \\ L_{min} < l(e_1) < L_{max} \\ L_{min} < l(e_2) < L_{max} \end{array} \right.$$

et Bo, un ouvrant défini par un ensemble de segments parallèles, pouvant posséder dans le voisinage des signes discriminants tels qu'un arc, et tel que Bo soit inclus dans un élément Bw.

$$B_o = \begin{cases} \{e_1, e_2, B_w, (e_3)\} \\ e_{1_{shape}} = e_{2_{shape}} = segment \\ e_{3_{shape}} = arc \\ e_1 \subset B_w \\ e_2 \subset B_w \\ |d(e_1, e_2) - d(B_{w_{e1}}, B_{w_{e2}})| < \epsilon \end{cases}$$

La notion d'inclusion d'un ouvrant dans un mur permet de généraliser l'identification d'un ouvrant à partir d'une discontinuité dans un mur selon un intervalle prédéfini relatif à la largeur possible des ouvrants.

A ce stade du procédé, le bâtiment est défini par des ensembles de murs et d'ouvrants qui seront par la suite modifiés pour corriger la topologie, inférer des murs manquants, homogénéiser les épaisseurs, etc.

La reconstruction globale de la maquette est fondée sur des mécanismes d'agrégation des éléments élémentaires identifiés dans l'image. Le procédé est défini en plusieurs étapes successives comme mentionné précédemment : une étape 206 de définition d'éléments extérieurs correspondant à la géométrie extérieure du bâtiment à partir des éléments graphiques, une étape 207 de définition d'éléments intérieurs correspondant aux éléments graphiques distincts des éléments extérieurs, et une étape 208 d'identification de zones du bâtiment formées par un ensemble d'éléments extérieurs et/ou intérieurs formant un polygone fermé et dont la surface est supérieure à une valeur de seuil, et éventuellement une étape 209 d'export.

Afin de garantir l'intégrité architecturelle, lors de l'étape 206, il s'agit d'extraire une forme fermée, c'est-à-dire d'identifier à partir des ensembles d'éléments un sous-ensemble d'éléments connectés deux à deux. Cette forme permet ainsi de définir l'empreinte globale du bâtiment.

A ce stade, il est nécessaire d'introduire la notion de topologie, c'est-à-dire les emplacements géométriques correspondant à des intersections entre les éléments. La topologie permet notamment de garantir que la forme est bien connexe et qu'il n'existe donc pas d'intervalle vide entre des murs, ce qui pourrait introduire un biais dans l'utilisation de la maquette générée selon l'application. Pour chaque intersection, un point topologique est créé :

$$P_t = (B_{w1}, B_{w2}, (x, y))$$

La forme extérieure est formalisée de la façon suivante : elle est définie par un ensemble de murs, en lien deux à deux, et tels que la forme soit connexe.

$$F_B = \begin{cases} \{\{B_{wO_i}\}_{i=3..n}, \{B_{o_j}\}_{j=1..p}, \{P_{t_k}\}_{k=3..q}\} \\ \forall B_o \in \{B_{o_j}\}_{j=1..p}, B_{o_{B_w}} \in \{B_{wO_i}\}_{i=3..n} \\ \forall B_w \in \{B_{wO_i}\}_{i=3..n}, \exists!(P_{t1}, P_{t2}) \in \{P_{t_k}\}_{k=3..q} \mid B_w \subset P_{t1} \text{ et } B_w \subset P_{t2} \end{cases}$$

Durant cette étape, des modifications peuvent être apportées aux éléments afin d'identifier des murs manquants, d'homogénéiser les épaisseurs de murs dans un même prolongement.

Une simplification des éléments est également opérée, afin de fusionner des murs en un seul, dans l'optique de limiter le nombre d'éléments. Cette fusion est par exemple effectuée sur des murs contigus, en prolongement dont les propriétés géométriques sont similaires (épaisseur, orientation). Cette simplification permet également de supprimer des murs incohérents, tels que des murs en chevauchement ou en inclusion totale.

Les éléments n'appartenant pas à la forme extérieure sont ensuite analysés et sont donc catégorisés en tant qu'éléments intérieurs. La différence réside essentiellement dans la topologie associée aux éléments intérieurs puisque le nombre de liens ne répond pas aux mêmes contraintes. Il est par exemple possible de conserver un mur intérieur n'ayant qu'une connexion topologique avec un autre élément du bâtiment. Des modifications sont également apportées sur ces éléments, afin de simplifier leur nombre, notamment en supprimant les éléments en inclusion totale, ou par la fusion d'éléments en prolongement.

Une dernière détection est appliquée (étape 208) pour identifier les espaces du bâtiment, c'est-à-dire les zones fermées dans le plan ou bien homogènes d'un point de vue thermique. Un espace est une zone du bâtiment formée par un ensemble de murs et d'ouvrants formant un polygone fermé, dont la surface totale As est supérieure à une valeur seuil, centré sur un élément du plan décrivant l'espace, par exemple un champ textuel issu de la reconnaissance initiale :

$$S = \left\{ \begin{array}{l} \{P_{t_k}\}_{k=3..n}, t_1 \\ t_1 \subset S \\ A_S > A_{min} \end{array} \right.$$

L'espace est ainsi délimité par un ensemble de murs et d'ouvrants, intérieurs ou extérieurs, formant un ensemble connexe, c'est-à-dire un ensemble d'éléments reliés formant une enveloppe fermée. Afin de limiter le nombre d'espaces possibles, aucun recouvrement entre deux espaces n'est possible.

Les algorithmes utilisés dans les étapes décrites ci-dessus impliquent un certain nombre de paramètres intervenant à différents stades de la reconstruction, depuis les étapes de prétraitement jusqu'à l'agrégation. Or, comme déjà expliqué, l'utilisateur peut être amené à choisir de mauvais paramètres ou des paramètres mal adaptés au cas de figure qu'il traite lors de la reconstruction. Il en résulte une maquette numérique 3D inappropriée.

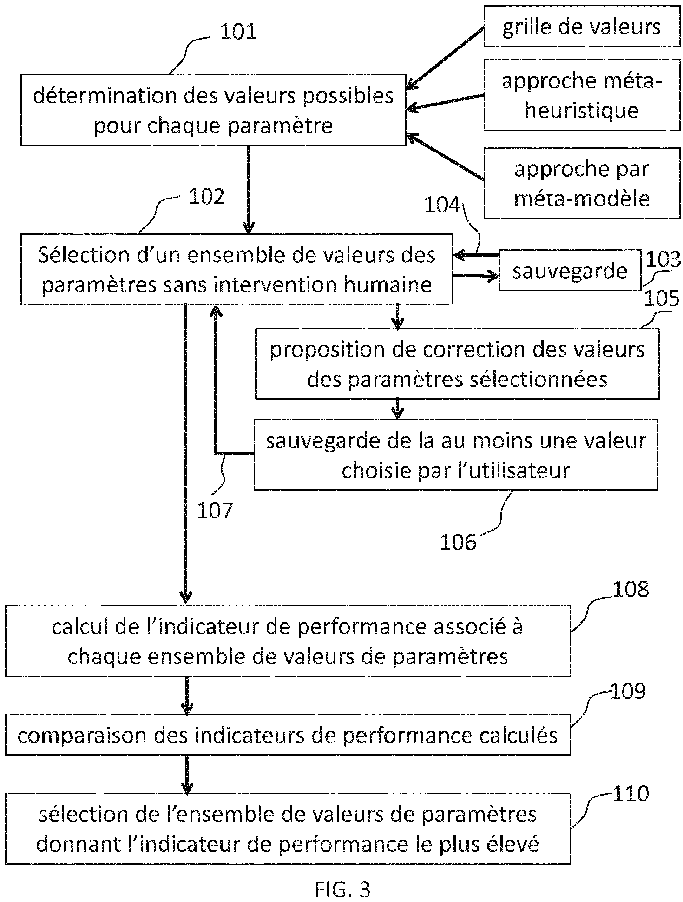

La **figure 3** représente schématiquement les étapes d'un autre mode de réalisation d'un procédé de construction d'une maquette numérique 3D d'un bâtiment à partir d'un plan 2D du bâtiment avec sélection d'un ensemble de valeurs des paramètres sans intervention humaine selon l'invention.

Parmi les paramètres intervenant durant le procédé de construction de la maquette numérique, on peut citer les paramètres internes des algorithmes, tels que, entre autres, le seuil de binarisation de l'image d'origine, le type de fonction utilisée pour la détection des contours, la contrainte sur l'orientation de la recherche de segments, le type de représentation de murs (mur homogènes noir ou blanc, représentation par des hachures), la densité de la zone de l'image pour la validation des murs, etc. La méthode de Hough implique une longueur minimale et maximale des segments, et peut tolérer une discontinuité dans les segments. On peut également citer les paramètres liés à la géométrie, tels que, entre autres, l'intervalle en pixels de l'épaisseur minimale et maximale des murs, le nombre d'épaisseurs possibles pour la représentation des murs, la résolution spatiale, la largeur minimale d'un ouvrant (porte, fenêtre), l'aire minimale d'un espace, etc.

Chaque paramètre peut prendre une valeur dans un ensemble prédéfini. Par exemple, le seuil de binarisation varie de 0 à 255, soit le nombre possible de niveaux de gris dans une image ou bien ramenés à des valeurs comparables par l'utilisateur. De même, l'épaisseur des murs peut prendre différentes valeurs possibles. Il en résulte une multitude de combinaisons possibles. La combinaison des paramètres a également son importance, puisque certains paramètres peuvent être interdépendants. Il est donc nécessaire de pouvoir évaluer plusieurs paramètres simultanément.

Il ressort que le choix des valeurs des paramètres est complexe. Ces paramètres dépendent des algorithmes de reconnaissance et des règles de reconstruction qui ne correspondent pas systématiquement au métier de l'utilisateur (architecte, bureau d'étude thermique, etc.). La variété des paramètres impliqués peut donc être un facteur limitant si l'utilisateur n'a pas à sa disposition de moyen simple pour comprendre ou choisir les valeurs de ces paramètres. L'idée générale de l'invention réside dans le fait que le procédé de construction comprend une étape 102 de sélection d'un ensemble de valeurs des paramètres sans intervention humaine.

Selon un mode de réalisation de l'invention, le procédé comprend en outre une étape de définition d'un indicateur de performance destiné à évaluer la performance d'un ensemble de valeurs de paramètres sélectionnées sans intervention humaine, dans lequel l'étape 102 de sélection d'un ensemble de valeurs des paramètres sans intervention humaine comprend une étape 108 de calcul de l'indicateur de performance associé à chaque ensemble de valeurs de paramètres, une étape 109 de comparaison des indicateurs de performance calculés, et une étape 110 de sélection de l'ensemble de valeurs de paramètres donnant l'indicateur de performance le plus élevé parmi tous les indicateurs de performance calculés. La performance est étroitement liée à la qualité de la reconstruction.

Quelle que soit l'approche de détermination des valeurs des paramètres, une approche automatisée implique de pouvoir évaluer la performance d'un ensemble de valeurs sélectionné, par calcul de l'indicateur de performance. Dans le contexte de la construction ou rénovation de bâtiment, il n'existe pas de référence à laquelle se comparer, c'est-à-dire une vérité terrain qui comptabilise de manière fiable la bonne reconstruction de maquette numérique. Dans le cas présent, une bonne reconstruction de maquette numérique est définie par le taux de reconstruction des éléments du bâtiment reconnus automatiquement. Une évaluation de la performance peut être établie à l'aveugle en comptabilisant le nombre d'éléments reconstruits pour chaque jeu de paramètres. L'indicateur peut donc être proportionnel à différentes valeurs, par exemple le nombre de murs détectés, le nombre d'ouvrants détectés, les longueurs totales des murs reconstruits, la longueur totale des ouvrants reconstruits, la surface du bâtiment reconstruit, le nombre de connexions topologiques entre les éléments du bâtiment.

Les deux premières indications portant sur le nombre de murs et d'ouvrants détectés peuvent cependant amener des erreurs de construction de la maquette numérique, notamment dans le cas de fausses détections, ou bien lorsque les murs sont identifiés partiellement par des segments ponctuels et discontinus. Ainsi, la longueur linéaire des éléments est un critère plus robuste, car cette évaluation limite le nombre d'éléments bruités contenant peu d'informations. De plus, un critère implicite pour évaluer la bonne reconstruction réside dans la cohérence structurelle de l'enveloppe du bâtiment. Un mur unique remplaçant plusieurs éléments sera donc plus pertinent pour la qualité de la représentation car il présente moins de risque d'erreur numérique durant les manipulations ultérieures. Afin de conforter les éléments reconstruits, il peut être intéressant d'évaluer la surface totale définie par le modèle estimé. Cette valeur peut, elle, être estimée simplement par les dimensions hors-tout du bâtiment, et permet notamment de fixer une limite supérieure à la sélection des paramètres, afin de ne pas ajouter des faux éléments. Un autre critère relatif à la cohérence structurelle est le nombre de connexions topologiques, c'est-à-dire le nombre de relations entre les éléments du bâtiment. Une connexion topologique assure en effet qu'il existe une intersection entre les éléments qui ne sont pas disjoints, ce qui serait contraire à la réalité.

L'évaluation de la performance peut être fondée sur un ou plusieurs critères. Avantageusement, l'indicateur de la performance est basé sur la longueur totale de tous les éléments et/ou le nombre de connexions de façon à garantir une bonne construction cohérente de la maquette numérique. L'indicateur de la performance peut par exemple être basé sur une combinaison linéaire de la longueur totale de tous les éléments et du nombre de connexions. Les valeurs des paramètres optimales doivent donc maximiser cet indicateur de performance, en respectant toutefois une valeur seuil de la surface reconstruite. La longueur des éléments peut être combinée de manière linéaire, ou bien en incluant une pondération, afin de privilégier par exemple une famille d'éléments plus pertinente pour la reconstruction, en particulier les murs. Selon les paramètres considérés, l'indicateur de performance le plus élevé est à comprendre comme un indicateur étant le plus adapté en fonction du paramètre géométrique considéré.

Selon un autre mode de réalisation, le procédé peut comprendre une étape 105 de proposition de correction des valeurs des paramètres sélectionnées sans intervention humaine, permettant à un utilisateur de choisir au moins une valeur d'au moins un paramètre, une étape 106 de sauvegarde de la au moins une valeur choisie par l'utilisateur, de façon à constituer un historique des choix de l'utilisateur, et l'étape 102 de sélection de l'ensemble des valeurs des paramètres sans intervention humaine se fait en prenant en compte l'historique des choix de l'utilisateur (étape 107).

Ce mode de réalisation peut être combiné au mode de réalisation faisant intervenir l'indicateur de performance, mais il peut aussi être pris isolément.

Selon un autre mode de réalisation, le procédé selon l'invention peut comprendre une étape 103 de sauvegarde de l'ensemble des valeurs de paramètres sélectionnées sans intervention humaine, de façon à constituer un historique des valeurs de paramètres, et l'étape 102 de sélection de l'ensemble des valeurs des paramètres sans intervention humaine se fait en prenant en compte l'historique des valeurs de paramètres (étape 104).

Ce mode de réalisation peut être combiné au mode de réalisation faisant intervenir l'indicateur de performance et/ou la proposition de correction, mais il peut aussi être pris isolément.

Préalablement à l'étape 102 de sélection de l'ensemble des valeurs des paramètres sans intervention humaine, le procédé selon l'invention peut comprendre une étape 101 de détermination des valeurs possibles pour chaque paramètre parmi une grille de valeurs pour chaque paramètre. Ce type de détermination est le plus intuitif et le plus facile à mettre en oeuvre. La recherche brute permet de balayer une grille de valeurs pour chaque paramètre. L'intérêt est de pouvoir répondre à toutes les formes possibles de problèmes, mais le temps de résolution est proportionnel au nombre de paramètres et de valeurs possibles pour chaque paramètre. Si le temps nécessaire pour une itération (c'est-à-dire l'exécution de l'algorithme pour un jeu de paramètres donné) est important, alors la résolution peut devenir non réalisable en un temps raisonnable. La solution consiste à diminuer le nombre de paramètres, ou limiter le nombre de valeurs possibles au détriment de la précision obtenue pour le résultat.

Alternativement, préalablement à l'étape 102 de sélection de l'ensemble des valeurs des paramètres sans intervention humaine, le procédé selon l'invention peut comprendre une étape 101 de détermination des valeurs possibles pour chaque paramètre par une approche méta-heuristique. Ce type de détermination consiste à naviguer dans un espace des paramètres durant plusieurs itérations, avec différentes possibilités de valeurs de paramètres. Avec une analogie à la génétique, une évolution des valeurs de paramètres à partir des meilleurs ensembles de valeurs de paramètres est possible grâce à des mécanismes de mutation et croisement sur les ensembles de paramètres.

Alternativement, préalablement à l'étape 102 de sélection de l'ensemble des valeurs des paramètres sans intervention humaine, le procédé selon l'invention peut comprendre une étape 101 de détermination des valeurs possibles pour chaque paramètre par une approche par méta-modèle.

L'approche par méta-modèle est fondée sur l'hypothèse qu'une fonction objectif est définie selon une fonction ou un hyperplan qui peut être inféré. Le principe général consiste à estimer les paramètres d'une fonction, par exemple un polynôme, qui soit un estimateur de la fonction de coût. Les paramètres sont ajustés à l'aide de points exemples issus de la véritable fonction coût, ici l'exécution d'une instance de reconstruction pour un jeu de paramètres fixé.

Le krigeage, ou krieging, est une technique d'interpolation statistique permettant d'approximer une fonction exacte dont l'exécution numérique est coûteuse par un modèle d'approximation (méta-modèle). Le méta-modèle est déterminé à l'aide d'un ensemble de points issus de la fonction exacte selon un processus itératif. Le principe consiste à choisir la meilleure fonction d'interpolation pour ces points connus, tout en étant capable d'approximer les incertitudes afin de pouvoir estimer la fonction initiale sur l'ensemble de l'espace.

La résolution permet d'approximer un modèle numérique donné $y(x)$ à l'aide de la combinaison d'une fonction de régression et d'un processus stochastique :

$$K(\mathrm{x}) \;=\; \mathcal{F}(\mathrm{x}) + \mathrm{z}(\mathrm{x})$$

où K est le modèle de krigeage (i.e. méta-modèle) approximant la réponse réelle $K(\mathrm{x}) \in \mathbb{R}$ pour un vecteur d'entrée de dimension $\mathrm{n} : \mathrm{x} \in \mathrm{D} \subset \mathbb{R}^{\mathrm{n}}$, $\mathcal{F}(\mathrm{x})$ la fonction de régression et z(x) le processus stochastique, $\mathrm{D} \subset \mathbb{R}^{\mathrm{n}}$ représente les contraintes (bornes) s'appliquant à la variable x.

Dans le cadre de l'invention, le modèle numérique dont on souhaite approximer le comportement est la valeur $y(\mathrm{x}) \in \mathbb{R}$ permettant de quantifier la qualité de reconstruction de la maquette numérique en fonction de différents paramètres de l'algorithme. La qualité de reconstruction (ou performance) peut dans notre cas être défini comme une combinaison linéaire de plusieurs indicateurs caractéristiques de la maquette reconstruite : longueur totale des murs, degré de connexité entre ces murs, nombre d'ouvrants identifiés.

Si l'on note y(x) l'indicateur de performance obtenu lors de l'application de l'algorithme selon un vecteur des paramètres de l'algorithme $\mathrm{x} \in \mathrm{D} \subset \mathbb{R}^{\mathrm{n}}$ (seuil de binarisation, épaisseur maximale d'un mur, etc.) et $\mathrm{D} \subset \mathbb{R}^{\mathrm{n}}$ est l'espace des solutions possibles physiquement, on cherche donc à approximer l'indicateur y(x) à l'aide du modèle de krigeage K(x) tel que : K (x) = $\mathcal{F}$(x) + z(x)

Dans le cadre du prototypage de l'invention, la fonction de régression F(x) est un modèle de régression polynomial consistant en une combinaison linéaire de p fonctions f(x) polynomiales combinant les variables d'entrée :

$$\mathcal{F}(\mathrm{x}) = \sum_{i=1}^{p} \beta_i f_i\left(x\right)$$

Où $\left(\beta_1, \ldots, \beta_p\right) \in \mathbb{R}^{p}$ sont les coefficients de régression.

La partie stochastique quant à elle est un processus gaussien centré caractérisé par sa fonction de covariance $cov(Z(x),Z(u)) = \sigma^2 R(x, u)$ où $\sigma^2$ représente la variance de Z et $R(x,u)$ représente la fonction de corrélation. Cette fonction de corrélation est une fonction de corrélation exponentielle.

Sur la base de ces hypothèses, le principe de l'algorithme de krigeage est de déterminer un ensemble de modèles de krigeage K valides (i.e. respectant un critère d'erreur prédéfini), puis d'identifier au sein de cet ensemble le modèle de krigeage donnant le meilleur résultat, et enfin, d'optimiser les paramètres d'entrée pour minimiser l'erreur. Ce processus est répété jusqu'à atteindre un critère de convergence prédéfini (seuil sur l'erreur d'estimation du modèle, nombre d'itérations maximal). Plus précisément, l'algorithme comprend les étapes suivantes :

1. Sélection au sein de l'espace des solutions d'un ensemble r d'échantillons des paramètres recherchés ($x_1$, ... , $x_r$) où $x_i \in \mathrm{D} \subset \mathbb{R}^{\mathrm{n}}$. Pour chacun de ces échantillons, exécution de l'algorithme de reconstruction et génération d'un vecteur ($y_1$, ... ,$y_r$) de valeurs de qualité de construction.

2. Création et calibrage d'un ensemble de modèles de krigeage $K_i$, i = 1 ... r, chaque modèle $K_i$, i = 1 ... r étant calibré à l'aide de l'ensemble des échantillons à l'exception de $x_i$

3. Vérification de la validité des modèles de krigeage à l'aide d'une validation croisée : chaque modèle est testé sur la base de l'échantillon $x_i$ et le critère de validité se base sur l'erreur constatée.

  ∘ Dans le cas où l'un (ou plusieurs) des modèles de krigeage est (sont) invalide(s), on ajuste l'échantillon ($x_1$, ... , $x_r$) et on exécute de nouveau l'algorithme sur les éléments de l'échantillon modifiés. On réitère ensuite l'étape 3 et ce jusqu'à l'obtention d'un échantillon valide.

4. Recherche au sein de l'échantillon du modèle de krigeage le plus performant et sur la base de ce dernier, recherche des valeurs des paramètres $x_{min}$ minimisant l'erreur (algorithme du gradient).

  ∘ Dans le cas où le critère de convergence (critère basé sur l'erreur) n'est pas atteint, on étend l'échantillon et on relance l'algorithme.

Une fois le modèle de Krigeage obtenu, il sera possible d'identifier les paramètres de l'algorithme de reconstruction permettant d'obtenir la meilleure qualité de construction. La résolution de la valeur optimale des paramètres de l'algorithme s'effectuera en appliquant une méthode d'optimisation cherchant à optimiser le critère de qualité, en l'occurrence maximiser la performance. L'intérêt du krigeage se révèle ici par la forme de sa formulation, celle-ci étant convexe, la résolution sera accessible par des méthodes classiques et rapides, telles que la descente de gradient.

La résolution du problème s'appuie donc sur l'estimation de la fonction par méta-modèle et la navigation dans l'espace des paramètres.

Ce dernier point est nécessaire pour générer de nouvelles observations, dans une démarche d'apprentissage actif, afin de pouvoir explorer au mieux l'espace des paramètres et mettre à jour l'estimateur de la fonction de coût. Pour ce faire, on choisit d'abord N points dans l'espace et on calcule la valeur de l'indicateur associé. Tant que la convergence n'a pas abouti, on estime le métamodèle et on ajoute des points et on calcule un indicateur de convergence associé. Les critères de convergence peuvent être par exemple un nombre maximum d'itérations ou un seuil sur la valeur de l'indicateur de performance, la stabilité. Le nombre d'itérations est un critère simple à mettre en oeuvre qui peut en outre être défini à partir d'une durée maximale de calcul. Ici, la valeur de performance, c'est-à-dire la quantité d'information reconstruite, est estimée en fonction du nombre d'éléments identifiés et reconstruits. Il est cependant difficile d'établir une valeur maximale de référence puisque la vérité terrain n'est pas connue. La stabilité reste un critère accessible, mais la notion de plateau reste toujours délicate à définir. La solution idéale est donc de combiner la valeur maximale de l'indicateur avec un seuil sur le nombre d'itérations, suffisamment élevé pour permettre la proposition d'une solution satisfaisante, sans toutefois pénaliser le temps de construction.

Un autre point délicat dans cette procédure réside dans l'ajout de points pour itérer et créer un nouveau modèle. Plusieurs options sont offertes afin soit de converger vers la valeur maximale de l'objectif, soit pour explorer les zones incertaines. Dans ce dernier cas, il faut définir des stratégies à base d'échantillonnage aléatoire ou des stratégies d'exploration intelligente utilisant par exemple une validation croisée permettant d'estimer les zones de plus forte incertitude couplées avec des points particuliers tels que le maximum ou le minimum. Ici, l'espace reste relativement restreint, et la fonction coût ne présente pas de forte discontinuité. La recherche de la valeur maximale de l'objectif est donc préférable.

Le procédé de construction de la maquette numérique 3D à partir d'un plan 2D selon l'invention comprend donc une étape 101 de détermination des valeurs que peuvent prendre tous les paramètres. Cette étape de détermination peut être réalisée au moyen de différentes approches (approche brute par balayage et test de toutes les valeurs possibles dans une grille de valeurs, approche par méta-heuristique avec optimisation par algorithme génétique de l'ensemble des valeurs des paramètres, approche par méta-modèle avec l'approximation de la forme de la fonction coût, aussi connue sous le nom de méthode du Krieging). Il s'agit d'une approche de détermination des valeurs automatisée. Une telle méthode nécessite de pouvoir évaluer la performance d'un ensemble de valeurs. Pour chaque ensemble de valeurs, un indicateur de performance est calculé, les indicateurs calculés sont comparés entre eux et l'ensemble de valeurs des paramètres donnant le meilleur indicateur de performance est sélectionné. Le procédé selon l'invention permet de sélectionner automatiquement le meilleur ensemble de valeurs des paramètres géométriques et internes aux algorithmes

Ainsi, un avantage majeur de l'invention réside dans la capacité de travailler automatiquement en sollicitant le minimum d'interventions de l'utilisateur. Il en résulte un gain de temps apporté et une facilité d'utilisation accrue car l'utilisateur n'a pas la nécessité de comprendre l'impact des paramètres appliqués, qui ne sont pas, a priori, dans ses compétences initiales.

Plusieurs applications peuvent bénéficier des avantages apportés par l'invention. Par exemple, l'invention peut apporter une aide à la conception d'un nouveau bâtiment et à la rénovation de bâtiment. Elle peut notamment être un support dans le choix des matériaux pour obtenir un bâtiment avec une gestion thermique optimale. Aussi, l'invention peut trouver une application dans le domaine de la sécurité pour l'évacuation des personnes lors d'incidents et la gestion des situations d'urgence.

L'invention concerne aussi un dispositif de construction d'une maquette numérique 3D à partir d'un plan 2D, le dispositif comprenant des moyens pour mettre en oeuvre les étapes du procédé selon l'invention.

L'invention concerne également un produit programme d'ordinateur, ledit programme d'ordinateur comprenant des instructions de code permettant d'effectuer les étapes du procédé de construction selon l'invention lorsque ledit programme est exécuté sur un ordinateur.

L'homme du métier considérera que la présente invention peut s'implémenter à partir d'éléments matériel et/ou logiciel et opérer sur un ordinateur, un tel ordinateur comprenant des moyens permettant d'opérer les étapes du procédé. L'ordinateur peut être couplé à un système de numérisation, un scanner, un appareil photo. L'invention peut aussi opérer sur une tablette équipée d'une caméra pour l'acquisition de l'image 2D. L'invention peut être disponible en tant que produit programme d'ordinateur sur un support lisible par un ordinateur. Le support peut être électronique, magnétique, optique, électromagnétique ou être un support de diffusion de type infrarouge. De tels supports sont par exemple, des mémoires à semiconducteur (Random Access Memory RAM, Read-Only Memory ROM), des bandes, des disquettes ou disques magnétiques ou optiques (Compact Disk - Read Only Memory (CD-ROM), Compact Disk - Read/Write (CD-R/W) et DVD).

**Revendications**

1. Procédé, mis en oeuvre par ordinateur, de construction d'une maquette numérique 3D (10) d'un bâtiment à partir d'un plan 2D (11, 12) du bâtiment sans connaissance de la vérité terrain dudit bâtiment, le bâtiment ayant une géométrie définie par au moins un paramètre géométrique, le procédé comprenant une pluralité d'étapes (204, 205), au moins l'une d'entre elles nécessitant une entrée d'au moins un paramètre interne, au moins deux paramètres parmi le au moins un paramètre géométrique et/ou le au moins un paramètre interne étant interdépendants, le procédé comprenant une étape (102) de sélection d'un ensemble de valeurs des paramètres parmi une pluralité d'ensembles de valeurs des paramètres comprenant les étapes suivantes :

   • fourniture du plan 2D (11, 12),
   • calcul d'un indicateur de performance correspondant à un taux de reconstruction des au moins un paramètre géométrique pour chaque ensemble de valeurs de paramètres (étape 108), destiné à évaluer la performance d'un ensemble de valeurs de paramètres sélectionnées,
   • comparaison des indicateurs de performance calculés (étape 109),
   • sélection automatique de l'ensemble de valeurs de paramètres donnant l'indicateur de performance le plus élevé parmi tous les indicateurs de performance calculés (étape 110), le procédé comprenant en outre une étape de génération de la maquette numérique 3D (10).

2. Procédé de construction selon la revendication 1, comprenant en outre :

   • une étape (105) de proposition de correction des valeurs des paramètres sélectionnées, permettant à un utilisateur de choisir au moins une valeur d'au moins un paramètre,
   • une étape (106) de sauvegarde de la au moins une valeur choisie par l'utilisateur, de façon à constituer un historique des choix de l'utilisateur,

   l'étape (102) de sélection de l'ensemble des valeurs des paramètres se faisant en prenant en compte l'historique des choix de l'utilisateur (étape 107).

3. Procédé de construction selon l'une quelconque des revendications 1 ou 2, comprenant en outre :

   • une étape (103) de sauvegarde de l'ensemble des valeurs de paramètres sélectionnées, de façon à constituer un historique des valeurs de paramètres,

   l'étape (102) de sélection de l'ensemble des valeurs des paramètres se faisant en prenant en compte l'historique des valeurs de paramètres (étape 104).

4. Procédé de construction selon l'une quelconque des revendications 1 à 3, le plan 2D comprenant des éléments graphiques, dans lequel la pluralité d'étapes comprend, avant la génération (205) de la maquette numérique 3D :

   • une étape (203) d'extraction des éléments graphiques du plan 2D,
   • une étape (204) d'identification des éléments graphiques de sorte à définir la géométrie du bâtiment.

5. Procédé de construction selon la revendication 4, comprenant, après l'étape (205) de génération de la maquette numérique 3D, une étape (209) d'export de la maquette numérique 3D dans un format préalablement défini.

6. Procédé de construction selon l'une quelconque des revendications 4 ou 5, dans lequel l'étape (205) de génération de la maquette numérique 3D comprend les étapes suivantes :

   • définition d'éléments extérieurs correspondant à la géométrie extérieure du bâtiment à partir des éléments graphiques (étape 206),
   • définition d'éléments intérieurs correspondant aux éléments graphiques distincts des éléments extérieurs (étape 207),
   • identification de zones du bâtiment formées par un ensemble d'éléments extérieurs et/ou intérieurs formant un polygone fermé et dont la surface est supérieure à une valeur de seuil (étape 208).

7.  Procédé de construction selon l'une quelconque des revendications 4 à 6, le plan 2D comprenant des éléments textuels, dans lequel l'étape (203) d'extraction des éléments graphiques est précédée d'une étape (202) d'extraction des éléments textuels.

8.  Procédé de construction selon l'une quelconque des revendications 4 à 7, comprenant au préalable une étape de numérisation du plan 2D pour obtenir une image numérisée.

9.  Procédé de construction selon l'une quelconque des revendications 1 à 8, comprenant, préalablement à l'étape (102) de sélection de l'ensemble des valeurs des paramètres, une étape (101) de détermination des valeurs possibles pour chaque paramètre parmi une grille de valeurs pour chaque paramètre.

10. Procédé de construction selon l'une quelconque des revendications 1 à 8, comprenant, préalablement à l'étape (102) de sélection de l'ensemble des valeurs des paramètres, une étape (101) de détermination des valeurs possibles pour chaque paramètre par une approche méta-heuristique.

11. Procédé de construction selon l'une quelconque des revendications 1 à 8, comprenant, préalablement à l'étape (102) de sélection de l'ensemble des valeurs des paramètres, une étape (101) de détermination des valeurs possibles pour chaque paramètre par une approche par méta-modèle.

12. Dispositif de construction d'une maquette numérique 3D à partir d'un plan 2D, le dispositif comprenant des moyens pour mettre en oeuvre les étapes du procédé selon l'une quelconque des revendications 1 à 11.

13. Produit programme d'ordinateur, ledit programme d'ordinateur comprenant des instructions de code permettant d'effectuer les étapes du procédé de construction selon l'une quelconque des revendications 1 à 11, lorsque ledit programme est exécuté sur un ordinateur.

**Patentansprüche**

1.  Computerimplementiertes Konstruktionsverfahren eines digitalen 3D-Modells (10) eines Gebäudes, anhand eines 2D-Plans (11, 12) des Gebäudes ohne Kenntnis der Felddaten des Gebäudes, wobei das Gebäude eine Geometrie aufweist, die durch mindestens einen geometrischen Parameter definiert ist, wobei das Verfahren eine Vielzahl von Schritten (204, 205) umfasst, wobei mindestens einer von ihnen eine Eingabe von mindestens einem internen Parameter erfordert, wobei mindestens zwei Parameter des mindestens einen geometrischen Parameters und/oder des mindestens einen internen Parameters voneinander abhängig sind, wobei das Verfahren einen Schritt (102) des Auswählens eines Satzes von Werten der Parameter aus einer Vielzahl von Sätzen von Werten der Parameter umfasst, der die folgenden Schritte umfasst:

    • Bereitstellen des 2D-Plans (11, 12),
    • Berechnen eines Leistungsindikators, der einer Rekonstruktionsrate der mindestens einen geometrischen Parameters für jeden Satz von Parameterwerten (Schritt 108) entspricht, um die Leistung eines Satzes von ausgewählten Parameterwerten zu bewerten
    • Vergleichen der berechneten Leistungsindikatoren (Schritt 109),
    • automatisches Auswählen des Satzes von Parameterwerten, der unter allen berechneten Leistungsindikatoren den höchsten Leistungsindikator ergibt (Schritt 110),

    wobei das Verfahren ferner einen Schritt des Erzeugens des digitalen 3D-Modells (10) umfasst.

2.  Konstruktionsverfahren nach Anspruch 1, ferner Folgendes umfassend:

    • einen Schritt (105) eines Korrekturvorschlags für die Werte der ausgewählten Parameter, der es einem Benutzer ermöglicht, mindestens einen Wert mindestens eines Parameters zu wählen,
    • einen Schritt (106) des Sicherns des mindestens einen vom Benutzer gewählten Werts, um eine Historie der Wahlen des Benutzers zu erstellen,

    wobei der Schritt (102) des Auswählens des Satzes der Werte der Parameter unter Berücksichtigung der Historie der Wahlen des Benutzers erfolgt (Schritt 107).

**3.** Konstruktionsverfahren nach einem der Ansprüche 1 oder 2, ferner Folgendes umfassend:

• einen Schritt (103) des Sicherns des Satzes der ausgewählten Parameterwerte, um eine Historie der Parameterwerte zu erstellen,

wobei der Schritt (102) des Auswählens des Satzes der Werte der Parameter unter Berücksichtigung der Historie der Parameterwerte erfolgt (Schritt 104).

**4.** Konstruktionsverfahren nach einem der Ansprüche 1 bis 3, wobei der 2D-Plan grafische Elemente umfasst, wobei die Vielzahl von Schritten vor dem Erzeugen (205) des digitalen 3D-Modells Folgendes umfasst:

• einen Schritt (203) des Extrahierens der grafischen Elemente aus dem 2D-Plan,
• einen Schritt (204) des Identifizierens der grafischen Elemente, um die Geometrie des Gebäudes zu definieren.

**5.** Konstruktionsverfahren nach Anspruch 4, umfassend nach dem Schritt (205) des Erzeugens des digitalen 3D-Modells. einen Schritt (209) des Exportierens des digitalen 3D-Modells in ein zuvor definiertes Format.

**6.** Konstruktionsverfahren nach einem der Ansprüche 4 oder 5, wobei der Schritt (205) des Erzeugens des digitalen 3D-Modells die folgenden Schritte umfasst:

• Definieren von äußeren Elementen, die der Außengeometrie des Gebäudes entsprechen, anhand der grafischen Elemente (Schritt 206),
• Definieren von inneren Elementen, die den von den äußeren Elementen getrennten grafischen Elementen entsprechen (Schritt 207),
• Identifizieren von Bereichen des Gebäudes, die durch einen Satz von äußeren und/oder inneren Elementen gebildet werden, die ein geschlossenes Polygon bilden und deren Fläche größer als ein Schwellenwert ist (Schritt 208).

**7.** Konstruktionsverfahren nach einem der Ansprüche 4 bis 6, wobei der 2D-Plan Textelemente umfasst, wobei dem Schritt (203) des Extrahierens der grafischen Elemente ein Schritt (202) des Extrahierens der Textelemente vorausgeht.

**8.** Konstruktionsverfahren nach einem der Ansprüche 4 bis 7, umfassend zuvor einen Schritt des Digitalisierens des 2D-Plans, um ein digitalisiertes Bild zu erzielen.

**9.** Konstruktionsverfahren nach einem der Ansprüche 1 bis 8, umfassend, vor dem Schritt (102) des Auswählens des Satzes der Werte der Parameter, einen Schritt (101) des Bestimmens der möglichen Werte für jeden Parameter aus einem Raster von Werten für jeden Parameter.

**10.** Konstruktionsverfahren nach einem der Ansprüche 1 bis 8, umfassend, vor dem Schritt (102) des Auswählens des Satzes der Werte der Parameter, einen Schritt (101) des Bestimmens der möglichen Werte für jeden Parameter durch einen metaheuristischen Ansatz.

**11.** Konstruktionsverfahren nach einem der Ansprüche 1 bis 8, umfassend, vor dem Schritt (102) des Auswählens des Satzes der Werte der Parameter, einen Schritt (101) des Bestimmens der möglichen Werte für jeden Parameter durch einen Metamodellansatz.

**12.** Konstruktionsvorrichtung eines digitalen 3D-Modells anhand eines 2D-Plans, wobei die Vorrichtung Mittel zum Umsetzen der Schritte des Verfahrens nach einem der Ansprüche 1 bis 11 umfasst.

**13.** Computerprogrammprodukt, wobei das Computerprogramm Codeanweisungen umfasst, die es ermöglichen, die Schritte des Konstruktionsverfahrens nach einem der Ansprüche 1 bis 11 durchzuführen, wenn das Programm auf einem Computer ausgeführt wird.

**Claims**

**1.** A method, implemented by computer, for constructing a 3D digital model (10) of a building from a 2D plan (11, 12) of the building without knowledge of the ground truth of said building, the building having a geometry defined by at least one geometrical parameter, the method comprising a plurality of steps (204, 205), at least one of said steps requiring an input of at least one internal parameter, at least two of the at least one geometric parameter and/or that least one internal parameter being interdependent, the method comprising a step (102) of selecting a set of values of the parameters out of a plurality of sets of values of the parameters, comprising the following steps:

- supply of the 2D plan (11, 12),
- computing a performance indicator corresponding to a rate of reconstruction of the at least one geometrical parameter for each set of parameter values (step 108), intended to evaluate the performance of a set of selected parameter values,
- comparing the computed performance indicators (step 109),
- automatically selecting the set of parameter values giving the highest performance indicator out of all the computed performance indicators (step 110),

the method further comprising a step of generation of the 3D digital model.

2. The construction method as claimed in claim 1, further comprising:

- a step (105) of proposing correction of the values of the selected parameters, allowing a user to choose at least one value of at least one parameter,
- a step (106) of saving the at least one value chosen by the user, so as to construct a history of the choices of the user,

the step (102) of selecting the set of the values of the parameters being done by taking into account the history of the choices of the user (step 107).

3. The construction method as claimed in either one of claims 1 or 2, further comprising:

- a step (103) of saving the set of selected parameter values, so as to construct a history of the parameter values,

the step (102) of selecting the set of the values of the parameters being done by taking account of the history of the parameter values (step 104).

4. The construction method as claimed in any one of claims 1 to 3, the 2D plan comprising graphic elements, wherein the plurality of steps comprises, before generating (205) the 3D digital model:

- a step (203) of extracting the graphic elements from the 2D plan,
- a step (204) of identifying the graphic elements so as to define the geometry of the building.

5. The construction method as claimed in claim 4, comprising, after the step (205) of generating the 3D digital model, a step (209) of exporting the 3D digital model in a previously defined format.

6. The construction method as claimed in either one of claims 4 and 5, wherein the step (205) of generating the 3D digital model comprises the following steps:

- defining external elements corresponding to the external geometry of the building from the graphic elements (step 206),
- defining internal elements corresponding to the graphic elements distinct from the external elements (step 207),
- identifying zones of the building formed by a set of external and/or internal elements forming a closed polygon and whose surface area is greater than a threshold value (step 208).

7. The construction method as claimed in any one of claims 4 to 6, the 2D plan comprising text elements, wherein the step (203) of extracting the graphic elements is preceded by a step (202) of extracting the text elements.

8. The construction method as claimed in any one of claims 4 to 7, comprising, previously, a step of digitizing the 2D plan to obtain a digitized image.

9. The construction method as claimed in any one of claims 1 to 8, comprising, prior to the step (102) of selecting the set of the parameter values, a step (101) of determining possible values for each parameter out of a grid of values for each parameter.

10. The construction method as claimed in any one of claims 1 to 8, comprising, prior to the step (102) of selecting the set of the parameter values, a step (101) of determining possible values for each parameter by a meta-heuristic approach.

11. The construction method as claimed in any one of claims 1 to 8, comprising, prior to the step (102) of selecting the set of the parameter values, a step (101) of determining possible values for each parameter by a meta-model approach.

12. A device for constructing a 3D digital model from a 2D plan, the device comprising means for implementing the steps of the method as claimed in any one of claims 1 to 11.

13. A computer program product, said computer program comprising code instructions making it possible to perform the steps of the construction method as claimed in any one of claims 1 to 11, when said program is run on a computer.

BALCON  4,95m²

Douche  WC  HALL  PLACARD  CUISINE
5,88m²  1,53  8,49m²  10,05m²

CHAMBRE 1  REPAS  TERRASSE BOIS
14,88m²  34,80m²  49,50m²

SEJOUR

11,10

8,50

**Plan du Rez de Chaussée**

échelle 1/100è soit 1cm pour 1m
alain meunier architecte d.p.l.g.

12

14  15

11

13

10

FIG.1

FIG. 2

FIG. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE GIMENEZ et al.** Automatic reconstruction of 3D building models from scanned 2D floor plans. *AUTOMATION IN CONSTRUCTION,* vol. 63, 48-56

- **DE OKORN et al.** Toward Automated Modeling of Floor Plans. *Proceedings of the 5th Symposium on 3D data processing*